(19) Europäisches Patentamt / European Patent Office / Office européen des brevets

(11) **EP 2 553 726 B1**

## (12) EUROPÄISCHE PATENTSCHRIFT

(45) Veröffentlichungstag und Bekanntmachung des Hinweises auf die Patenterteilung:
**19.09.2018   Patentblatt 2018/38**

(21) Anmeldenummer: **11708034.1**

(22) Anmeldetag: **10.03.2011**

(51) Int Cl.:
*H01L 27/15* (2006.01)   *H01L 33/38* (2010.01)
*H01L 25/075* (2006.01)   *H01L 33/00* (2010.01)
*H01L 33/44* (2010.01)   *H01L 33/20* (2010.01)
*H01L 33/22* (2010.01)   *H01L 33/40* (2010.01)

(86) Internationale Anmeldenummer:
**PCT/EP2011/053638**

(87) Internationale Veröffentlichungsnummer:
**WO 2011/120775 (06.10.2011 Gazette 2011/40)**

(54) **OPTOELEKTRONISCHER HALBLEITERCHIP**

OPTOELECTRONIC SEMICONDUCTOR CHIP

PUCE À SEMI-CONDUCTEURS OPTOÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.03.2010   DE 102010013494**

(43) Veröffentlichungstag der Anmeldung:
**06.02.2013   Patentblatt 2013/06**

(73) Patentinhaber: **OSRAM Opto Semiconductors GmbH**
**93055 Regensburg (DE)**

(72) Erfinder: **VON MALM, Norwin**
**93152 Nittendorf - Thumhausen (DE)**

(74) Vertreter: **Epping - Hermann - Fischer Patentanwaltsgesellschaft mbH**
**Postfach 20 07 34**
**80007 München (DE)**

(56) Entgegenhaltungen:
**EP-A1- 0 921 577        DE-A1-102007 022 947**
**DE-A1-102008 011 848     DE-A1-102008 034 560**
**US-A1- 2006 049 335**

**Beschreibung**

Es wird ein optoelektronischer Halbleiterchip, ein optoelektronisches Halbleiterbauteil sowie ein Verfahren zur Herstellung eines optoelektronischen Halbleiterbauteils angegeben.

Eine zu lösende Aufgabe besteht darin, einen besonders kompakten und kostengünstig herstellbaren Halbleiterchip anzugeben.

Gemäß zumindest einer Ausführungsform der Erfindung umfasst der optoelektronische Halbleiterchip einen Halbleiterkörper, der einen n-leitenden Bereich und einen p-leitenden Bereich aufweist. N- und p-leitender Bereich können zumindest stellenweise durch epitaktisch gewachsene Halbleiterschichtenfolgen des Halbleiterkörpers gebildet sein.

Weiterhin umfasst der optoelektronische Halbleiterchip ein einziges n-Kontaktelement, über das der n-leitende Bereich durch den p-leitenden Bereich hindurch elektrisch kontaktierbar ist. Mit anderen Worten wird der n-leitende Bereich durch den p-leitenden Bereich also von der p-Seite her elektrisch kontaktiert. Dabei bedeutet "ein einziges n-Kontaktelement", dass das n-Kontaktelement nicht durch eine Vielzahl von einzelnen n-Kontaktelementen beispielsweise durch Halbleitermaterial des Halbleiterkörpers voneinander getrennte n-Kontaktelemente gebildet ist. Vielmehr handelt es sich bei dem einzigen n-Kontaktelement um ein Kontaktelement, welches sich zusammenhängend und durchgehend innerhalb des Halbleiterkörpers erstreckt und seitlich zumindest stellenweise an Halbleitermaterial des Halbleiterkörpers direkt angrenzt.

Um ein optoelektronisches Halbleiterbauteil anzugeben, das besonders einfach im Aufbau sowie alterungsstabil und kostengünstig ist, macht der hier beschriebene optoelektronische Halbleiterchip unter anderem von der Idee Gebrauch, den n-leitenden Bereich eines Halbleiterkörpers des Halbleiterchips über ein einziges n-Kontaktelement, welches durch den p-leitenden Bereich des Halbleiterkörpers hindurch verläuft, elektrisch kontaktierbar zu machen. Vorteilhaft kann so auf das Aufbringen einer Kontaktierung auf Außenflächen des n-seitigen Bereichs oder auf eine Vielzahl von einzelnen Kontaktelementen verzichtet werden, da der n-leitende Bereich über das einzige n-Kontaktelement von der p-Seite her kontaktiert ist.

Gemäß zumindest einer Ausführungsform der Erfindung umfasst der optoelektronische Halbleiterchip einen Halbleiterkörper, der einen n-leitenden und einen p-leitenden Bereich aufweist. Ferner umfasst der optoelektronische Halbleiterchip ein einziges n-Kontaktelement, über das der n-leitende Bereich durch den p-leitenden Bereich hindurch elektrisch kontaktierbar ist.

Weiterhin umfasst das n-Kontaktelement eine Ausnehmung im p-leitenden Bereich. "Ausnehmung" bedeutet in diesem Zusammenhang, dass im Bereich einer solchen stellenweise Halbleitermaterial des p-leitenden Bereichs entfernt ist. Die Ausnehmung ist daher in lateraler Richtung, das heißt in einer Richtung parallel zu einer Haupterstreckungsebene des Halbleiterkörpers, zumindest stellenweise von dem p-leitenden Bereich begrenzt. Denkbar ist, dass die Ausnehmung durch zumindest eine Seitenfläche, eine Bodenfläche sowie eine der Bodenfläche gegenüberliegende Öffnung gebildet ist. Die Bodenfläche und die Öffnung sind dann durch die zumindest eine Seitenfläche miteinander verbunden. Die zumindest eine Seitenfläche kann vollständig durch Halbleitermaterial des p-leitenden Bereichs gebildet sein. Ferner kann die Bodenfläche der Ausnehmung vollständig durch das Halbleitermaterial des n-leitenden Bereichs gebildet sein. Mit anderen Worten beträgt eine vertikale Ausdehnung, das heißt die Ausdehnung der Ausnehmung in einer Richtung senkrecht zur Haupterstreckungsebene des Halbleiterkörpers, zumindest stellenweise eine vertikale Ausdehnung, das heißt Dicke, des p-leitenden Bereichs. Die Ausnehmung ist dann ein Loch im p-leitenden Bereich, das diesen vollständig durchdringt.

Weiterhin begrenzt das n-Kontaktelement, insbesondere die Ausnehmung, den p-leitenden Bereich zumindest stellenweise lateral. Beispielsweise berandet dann die Ausnehmung den p-leitenden Bereich zumindest stellenweise. Ebenso ist denkbar, dass die Ausnehmung den p-leitenden Bereich in lateraler Richtung allseitig begrenzt. Die Ausnehmung ist dann in einer Draufsicht auf den Halbleiterchip "umlaufend" und bildet ein zusammenhängendes Gebiet aus.

Weiterhin weist das n-Kontaktelement eine n-Anschlussfläche auf, die durch ein Halbleitermaterial des n-leitenden Bereichs gebildet ist, wobei die n-Anschlussfläche senkrecht zu einer Wachstumsrichtung des Halbleiterkörpers verläuft. Umfasst das einzige n-Kontaktelement eine Ausnehmung im p-leitenden Bereich, so ist denkbar, dass die n-Anschlussfläche vollständig durch die Bodenfläche der Ausnehmung gebildet ist. Ist die Ausnehmung beispielsweise umlaufend, so ist denkbar, dass die n-Anschlussfläche ebenso umlaufend, beispielsweise in einer Draufsicht kreisförmig, rechteckförmig und/oder oval, um den p-leitenden Bereich herum verläuft.

Weiterhin weist der Halbleiterkörper eine Strahlungsauskoppelfläche auf, die an der dem p-leitenden Bereich abgewandten Seite des n-leitenden Bereichs angeordnet ist. Beispielsweise ist die Strahlungsauskoppelfläche vollständig durch die dem p-leitenden Bereich abgewandten Seite des n-leitenden Bereichs gebildet. Ebenso ist es möglich, dass auf freie Stellen des n-leitenden Bereichs eine oder mehrere Schichten aufgebracht sind. Beispielsweise ist dann auf freie Stellen des n-leitenden Bereichs eine Passivierungsschicht aufgebracht. Die dem p-leitenden Bereich abgewandte Seite der Passivierungsschicht kann dann die Strahlungsauskoppelfläche bilden.

Weiterhin weist das n-Kontaktelement eine n-Kontaktmetallisierung auf, die zumindest stellenweise an die n-Anschlussfläche angrenzt. Mittels der n-Kontaktmetallisierung ist der n-leitende Bereich über die n-Anschlussfläche des n-Kontaktelements elektrisch kontaktierbar. Umfasst das n-Kontaktelement beispielsweise eine Ausnehmung, so ist denkbar, dass die n-Kontaktmetallisierung über die gesamte laterale Ausdehnung der n-Anschlussfläche mit dieser in direktem Kontakt steht, wobei zwischen der n-Kontaktmetallisierung und dem p-leitenden Bereich eine Passivierungsschicht, beispielsweise eine elektrische Isolationsschicht, angeordnet ist. Beispielsweise ist die Ausnehmung dann mit einem Metall zumindest teilweise befüllt.

Weiterhin weist der p-leitende Bereich eine der Strahlungsauskoppelfläche gegenüberliegende p-Anschlussfläche auf, wobei die p-Anschlussfläche mit einer p-Kontaktmetallisierung elektrisch leitend verbunden ist. Beispielsweise steht die p-Kontaktmetallisierung in direktem Kontakt mit der p-Anschlussfläche. Ebenso ist denkbar, dass zwischen der p-Kontaktmetallisierung und der p-Anschlussfläche zumindest stellenweise eine oder mehrere elektrisch leitfähige Schichten, zum Beispiel Spiegelschichten, angeordnet sind.

Weiterhin sind die n- und die p-Kontaktmetallisierung in lateraler Richtung vom Halbleiterkörper herausgeführt und überlappen in vertikaler Richtung nicht miteinander. Mit anderen Worten sind die n- und die p-Kontaktmetallisierung in lateraler Richtung versetzt zueinander angeordnet. Beispielsweise kann dies besonders vorteilhaft dadurch erreicht werden, dass die n- und die p-Kontaktmetallisierung durch eine derart strukturierte Kontaktschicht hergestellt sind, dass sich in vertikaler Richtung die n- und p-Kontaktmetallisierung nicht überschneiden. Sowohl der n- als auch der p-leitende Bereich sind daher über die n- und die p-Kontaktmetallisierung von außen "seitlich" elektrisch kontaktiert.

Gemäß zumindest einer weiteren Ausführungsform des optoelektronischen Halbleiterchips weist der Halbleiterkörper eine aktive Zone auf, wobei die n-Anschlussfläche des n-Kontaktelements wenigstens 1 % und höchstens 10 %, bevorzugt wenigstens 2 % und höchstens 5 %, einer Querschnittsfläche der aktiven Zone beträgt. Bei der aktiven Zone kann es sich um eine Schicht handeln, die im Betrieb des Halbleiterchips elektromagnetische Strahlung in einem Wellenlängenbereich innerhalb des ultravioletten bis infraroten Spektralbereichs der elektromagnetischen Strahlung emittiert. Die aktive Zone ist zwischen dem n-leitenden Bereich und dem p-leitenden Bereich angeordnet. Die Querschnittsfläche der aktiven Zone ist dabei die Fläche, welche senkrecht zur Wachstumsrichtung des Halbleiterkörpers verläuft. Es hat sich herausgestellt, dass ein derartiger Flächenbereich des n-Kontaktelements im Verhältnis zur Querschnittsfläche der aktiven Zone einen besonders günstigen Kontaktwiderstand ergibt. Beispielsweise können mit einer derart beschaffenen n-Anschlussfläche besonders hohe Wärmeentwicklungen im Bereich der Anschlussfläche bei elektrischer Kontaktierung vermieden werden.

Gemäß zumindest einer weiteren Ausführungsform beträgt ein Verhältnis aus einer maximalen lateralen Ausdehnung der aktiven Zone und einer n-Querleitfähigkeit des n-leitenden Bereichs wenigstens $2 \ \mu m/(\Omega/sq)$ und höchstens $8 \ \mu m/(\Omega/sq)$, bevorzugt wenigstens $3 \ \mu m/(\Omega/sq)$ und höchstens $5 \ \mu m/(\Omega/sq)$. Ist die aktive Zone in einer Draufsicht beispielsweise kreisförmig, kann die maximale laterale Ausdehnung ein Durchmesser der aktiven Zone sein. Für den Fall, dass die aktive Zone beispielsweise rechteckförmig ist, kann die maximale laterale Ausdehnung ein diagonaler Abstand zweier Eckpunkte der aktiven Zone sein. Dabei sind die geometrischen Abmaße der aktiven Zone derart gewählt, dass die n-Querleitfähigkeit des n-leitenden Bereichs ausreicht, um eine im Betrieb des optoelektronischen Halbleiterchips im Wesentlichen homogene Stromverteilung im n-leitenden Bereich zu erzeugen, sodass die aktive Zone selbst entlang ihrer Querschnittsfläche möglichst homogen elektromagnetische Strahlung emittiert. "Im Wesentlichen" bedeutet hierbei, dass die Stromverteilung entlang des n-leitenden Bereichs zu wenigstens 80%, bevorzugt zu wenigstens 90% konstant ist.

Gemäß zumindest einer weiteren Ausführungsform ist zwischen dem p-leitenden Bereich und der n-Kontaktmetallisierung im Bereich der Ausnehmung eine Isolationsschicht angeordnet. Vorzugsweise steht die Isolationsschicht sowohl mit der p-Kontaktmetallisierung als auch mit dem n-leitenden Bereich in direktem Kontakt und isoliert den n-leitenden Bereich und die p-Kontaktmetallisierung elektrisch voneinander. Gemäß zumindest einer Ausführungsform ist der p-leitende Bereich stellenweise von einem nominell undotierten Halbleiterbereich lateral begrenzt, wobei der nominell undotierte Halbleiterbereich und der p-leitende Bereich durch eine durchgehende und zusammenhängende Halbleiterschicht gebildet sind. "Nominell undotiert" bedeutet in diesem Zusammenhang, dass der Halbleiterbereich im Vergleich zu an den Halbleiterbereich direkt angrenzenden p-leitenden und/oder n-leitenden Bereich eine vernachlässigbare effektive Dotierung aufweist. Beispielsweise handelt es sich bei dem nominell undotierten Halbleiterbereich um einen Halbleiterbereich, dessen Halbleitermaterial einen hohen elektrischen Widerstand im Vergleich zum n-leitenden und/oder p-leitenden Bereich aufweist. Vorzugsweise ist der nominell undotierte Halbleiterbereich aus dem Halbleitermaterial des p-leitenden Bereichs gebildet. Beispielsweise ist dazu der p-leitende Bereich im Bereich des späteren nominell undotierten Halbleiterbereichs mittels Ionenimplantation oder einer Plasmabehandlung zu dem nominell undotierten Halbleiterbereich verändert. Vorteilhaft kann der nominell undotierte Bereich als eine Isolationsschicht dienen, sodass auf eine zusätzliche Einbringung einer Isolationsschicht zwischen dem n-leitenden Bereich und der p-Kontaktmetallisierung vorteilhaft verzichtet werden kann.

Gemäß zumindest einer weiteren Ausführungsform ist das n-Kontaktelement zumindest stellenweise durch ein überdotiertes n-leitendes Halbleitermaterial des p-leitenden Bereichs gebildet. Zum Beispiel ist der p-leitende Bereich an Stellen des überdotierten Halbleitermaterials mittels Ionenimplantation oder eines Plasmabehandlungsverfahrens in seiner Dotierung beispielsweise derart verändert, dass mittels des Verfahrens das Halbleitermaterial des p-leitenden Bereichs an diesen Stellen n-leitend ist. Vorteilhaft kann dann das n-Kontaktelement zumindest teilweise durch das überdotierte Halbleitermaterial gebildet sein, sodass beispielsweise auf Kontaktmetallisierungen im Bereich des n-Kontaktelements zumindest teilweise verzichtet werden kann. Das überdotierte n-leitende Halbleitermaterial kann dann teilweise die n-Kontaktmetallisierung ersetzen.

Es wird darüber hinaus ein optoelektronisches Halbleiterbauteil angegeben.

Gemäß zumindest einer Ausführungsform umfasst das optoelektronische Halbleiterbauteil zumindest zwei optoelektronische Halbleiterchips gemäß einer der oben beschriebenen Ausführungsformen. Das heißt, die für den hier beschriebenen optoelektronischen Halbleiterchip aufgeführten Merkmale sind auch für das hier beschriebene optoelektronische Halbleiterbauteil offenbart.

Weiterhin sind die optoelektronischen Halbleiterchips in einer Serienschaltung miteinander elektrisch kontaktiert. Damit wird erreicht, dass das optoelektronische Halbleiterbauteil in einem Betrieb bei vorgebbarer Helligkeit einen deutlich geringeren Stromfluss aufweist. Das optoelektronische Halbleiterbauteil kann somit spannungsgetrieben bei gleichzeitig niedrigen Strömen gespeist werden. Dadurch lassen sich beispielsweise teure Treiberstufen sowie Hochstromquellen durch entsprechende Hochspannungsquellen ersetzen, welche leicht zu fertigen sind.

Weiterhin ist der n-leitende Bereich eines Halbleiterchips mit dem p-leitenden Bereich eines benachbarten Halbleiterchips über eine durchgehende Zwischenmetallisierung elektrisch verbunden.

Weiterhin ist die Zwischenmetallisierung zumindest stellenweise durch die n-Kontaktmetallisierung eines Halbleiterchips und durch die p-Kontaktmetallisierung eines benachbarten Halbleiterchips gebildet. Mit anderen Worten sind die jeweiligen Kontaktmetallisierungen, welche lateral von den jeweiligen Halbleiterkörpern in Richtung zueinander herausgeführt sind, zusammen zu einer Zwischenmetallisierung "verbunden", sodass mittels der Zwischenmetallisierung der n-leitende Bereich des einen Halbleiterchips auf demselben elektrischen Potenzial wie der p-leitende Bereich des benachbarten Halbleiterchips liegt.

Gemäß zumindest einer Ausführungsform umfasst das optoelektronische Halbleiterbauteil zumindest zwei optoelektronische Halbleiterchips gemäß einer der oben beschriebenen Ausführungsformen, wobei die optoelektronischen Halbleiterchips in einer Serienschaltung miteinander elektrisch kontaktiert sind. Der n-leitende Bereich eines Halbleiterchips ist mit dem p-leitenden Bereich eines benachbarten Halbleiterchips über eine durchgehende Zwischenmetallisierung elektrisch verbunden. Die Zwischenmetallisierung ist zumindest stellenweise durch die n-Kontaktmetallisierung eines Halbleiterchips und durch die p-Kontaktmetallisierung eines benachbarten Halbleiterchips gebildet. Besonders vorteilhaft ist eine Serienschaltung von gerade so vielen Halbleiterchips, dass das optoelektronische Halbleiterbauteil bei einer vorgebbaren Bestromungshöhe mit einer der folgenden bevorzugten extern an das Halbleiterbauteil angelegten Spannungshöhen betrieben werden kann: 55 V, $53\sqrt{2}$ V, 110 V, $110\sqrt{2}$ V, 220 V, $200\sqrt{2}$ V.

Gemäß zumindest einer weiteren Ausführungsform ist ein Verbund bestehend aus den optoelektronischen Halbleiterchips und den Metallisierungen auf einem Hilfsträger aufgebracht. Das kann heißen, dass der Verbund in direktem Kontakt mit dem Hilfsträger steht. Ebenso ist denkbar, dass zwischen dem Verbund und dem Hilfsträger eine oder mehrere Schichten angeordnet sind. Der Hilfsträger ist von einem Aufwachssubstrat verschieden. Beispielsweise handelt es sich bei dem Hilfsträger um eine mechanisch stabile Schicht oder um eine Platte, die beispielsweise mit einem Metall gebildet ist. Ebenso kann der Hilfsträger ein Halbleiterwafer sein.

Es wird darüber hinaus ein Verfahren zur Herstellung eines optoelektronischen Halbleiterbauteils angegeben.

Mittels des Verfahrens wird ein Halbleiterbauteil hergestellt, wie es in Verbindung mit einem oder mehreren der oben genannten Ausführungsformen beschrieben ist. Das heißt die für das hier beschriebene optoelektronische Halbleiterbauteil aufgeführten Merkmale sind auch für das hier beschriebene Verfahren offenbart und umgekehrt. In einem ersten Schritt wird ein Aufwachsträger bereitgestellt. Der Aufwachsträger kann beispielsweise nach Art einer Scheibe oder einer Platte ausgebildet sein. Beispielsweise handelt es sich bei dem Aufwachsträger um einen einkristallinen Wafer, der mit einem Halbleiter- oder Isolationsmaterial gebildet ist.

In einem nächsten Schritt wird eine Halbleiterschichtenfolge auf den Aufwachsträger epitaktisch abgeschieden, wobei die Halbleiterschichtenfolge einen n-leitenden Bereich und einen p-leitenden Bereich aufweist.

In einem weiteren Schritt werden zumindest zwei n-Kontaktelemente in der Halbleiterschichtenfolge erzeugt, wobei sich die n-Kontaktelemente durch den p-leitenden Bereich hindurch bis in den n-leitenden Bereich hinein erstrecken. Beispielsweise umfassen die zwei n-Kontaktelemente eine Ausnehmung. Denkbar ist dann, dass die Ausnehmungen mittels eines trocken- oder nasschemischen Ätzprozesses in die Halbleiterschichtenfolge eingebracht werden. "Hinein erstrecken" heißt in diesem Zusammenhang, dass die n-Kontaktelemente zumindest eine vertikale Ausdehnung aufweisen, die zumindest stellenweise wenigstens der vertikalen Ausdehnung des p-leitenden Bereichs entspricht. Mit anderen Worten grenzen die n-Kontaktelemente dann stellenweise an das Halbleitermaterial des n-leitenden Bereichs direkt an. Die Kontaktelemente können aber auch eine vertikale Ausdehnung aufweisen, die größer als die des n-leitenden Bereichs ist.

In einem nächsten Schritt wird ein Hilfsträger auf die dem Aufwachsträger gegenüberliegende Fläche der Halbleiterschichtenfolge aufgebracht. Dabei muss der Hilfsträger nicht zwingend mit der Halbleiterschichtenfolge in direktem Kontakt stehen. Beispielsweise können zwischen dem Hilfsträger und der Halbleiterschichtenfolge eine oder mehrere Schichten, wie zum Beispiel Metallisierungen angeordnet sein. Dabei können die Metallisierungen zur späteren elektrischen Kontaktierung des optoelektronischen Halbleiterbauteils dienen. Bei dem Hilfsträger kann es sich wiederum um einen Halbleiterwafer handeln, der nach Art einer Scheibe oder Platte ausgebildet ist.

In einem nächsten Schritt werden einzelne Halbleiterkörper durch Einbringen von zumindest einem Graben über den n-leitenden Bereich zwischen in lateraler Richtung benachbarten n-Kontaktelementen erzeugt. Im Bereich des Grabens sind Teile der Halbleiterschichtenfolge zumindest stellenweise vollständig entfernt. Beispielsweise wird der zumindest eine Graben mittels mindestens eines trocken- und/oder nasschemischen Ätzprozesses oder einer anderen Form des Materialabtrags in die Halbleiterschichtenfolge eingebracht. Das heißt, dass der zumindest eine Graben zumindest stellenweise seitlich durch die Halbleiterschichtenfolge begrenzt ist. Denkbar ist in diesem Zusammenhang, dass der zumindest eine Graben eine einer Öffnung des Grabens gegenüberliegende Bodenfläche sowie zwei Seitenflächen aufweist, welche durch die Bodenfläche miteinander verbunden sind. Die Seitenflächen können dann vollständig durch die Halbleiterschichtenfolge gebildet sein, wobei die Bodenfläche des Grabens beispielsweise durch die Oberfläche des Hilfsträgers gebildet ist. Es handelt sich bei dem Graben also um eine Ausnehmung in der Halbleiterschichtenfolge.

Die Erfindung offenbart einen optoelektronischen Halbleiterchip gemäß Patentanspruch 1, ein optoelektronisches Halbleiterbauteil gemäß Anspruch 8 und dessen Herstellungsverfahren gemäß Patentanspruch 9. Besondere Ausführungsformen der Erfindung sind in den abhängigen Patentansprüchen angegeben.

Im Folgenden werden der hier beschriebene optoelektronische Halbleiterchip, das hier beschriebene optoelektronische Halbleiterbauteil sowie das hier beschriebene Verfahren anhand von Ausführungsbeispielen und den dazugehörigen Figuren näher erläutert.

Die Figuren 1A und 1B zeigen eine Seitenan- und Draufsicht eines Ausführungsbeispiels eines hier beschriebenen optoelektronischen Halbleiterchips.

Die Figuren 2, 3, 4 und 5 zeigen schematische Schnittdarstellungen einzelner Ausführungsbeispiele eines hier beschriebenen optoelektronischen Halbleiterbauteils.

Die Figuren 6A bis 6E zeigen anhand von schematischen Schnittdarstellungen einzelne Fertigungsschritte zur Herstellung eines Ausführungsbeispiels eines hier beschriebenen optoelektronischen Halbleiterbauteils.

In den Ausführungsbeispielen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

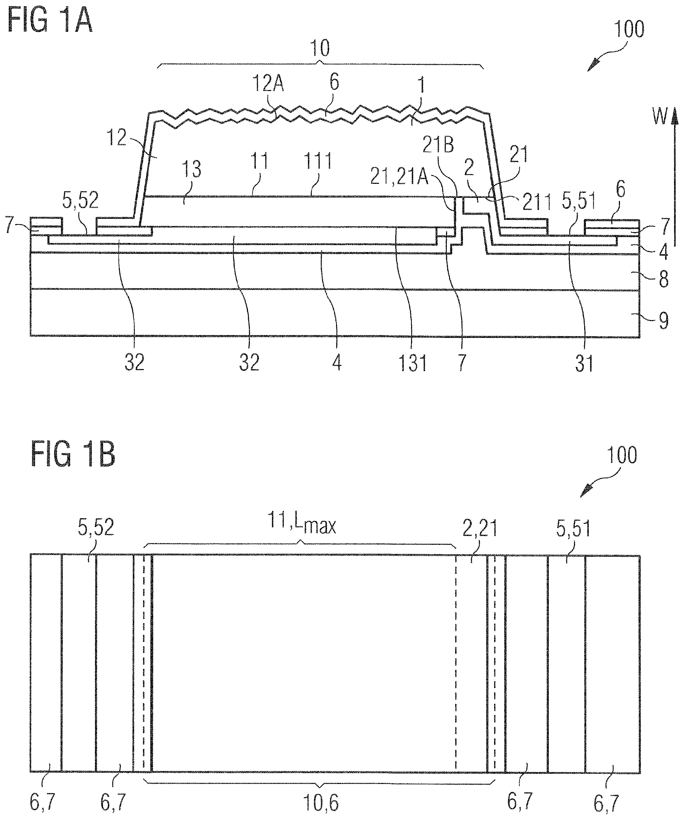

In der Figur 1A ist anhand einer schematischen Schnittdarstellung ein hier beschriebener optoelektronischer Halbleiterchip 100 mit einem Halbleiterkörper 1 gezeigt. Der Halbleiterkörper 1 weist einen n-leitenden Bereich 12 und einen p-leitenden Bereich 13, sowie eine aktive Zone 11 auf, die im Betrieb des Halbleiterchips 100 elektromagnetische Strahlung emittiert. Die aktive Zone 11 ist zwischen dem n-leitenden Bereich 12 und dem p-leitenden Bereich 13 angeordnet. Auf eine der aktiven Zone 11 gegenüberliegende Fläche 12A des n-leitenden Bereichs 12 ist eine Passivierungsschicht 6 direkt aufgebracht, wobei eine Strukturierung der Fläche 12A zumindest stellenweise auf die Passivierungsschicht 6 übertragen ist. Mit anderen Worten ist eine Strahlungsauskoppelfläche 10 des Halbleiterchips 100 durch die dem Halbleiterkörper 1 abgewandte Fläche der Passivierungsschicht 6 gebildet.

Ferner weist der optoelektronische Halbleiterchip 100 ein einziges n-Kontaktelement 2 auf. Über das n-Kontaktelement 2 ist der n-leitende Bereich 12 durch den p-leitenden Bereich 13 hindurch elektrisch kontaktiert. Das n-Kontaktelement 2 umfasst eine Ausnehmung 21 im p-leitenden Bereich, wobei die Ausnehmung 21 den p-leitenden Bereich 13 stellenweise lateral begrenzt. Ferner weist das n-Kontaktelement 2 eine n-Anschlussfläche 211 auf. Die n-Anschlussfläche 211 ist ausschließlich durch ein Halbleitermaterial des n-leitenden Bereichs 12 gebildet. Vorliegend weist die Ausnehmung 21 eine Seitenfläche 21A und eine Bodenfläche 21B auf. Die Seitenfläche 21A ist vollständig durch ein Halbleitermaterial des p-leitenden Bereichs 13 gebildet, wobei eine maximale vertikale Ausdehnung der Ausnehmung 21 zumindest die vertikale Ausdehnung, das heißt Dicke, des p-leitenden Bereichs 13 beträgt. Ferner ist die Bodenfläche 21B vollständig durch das Halbleitermaterial des n-leitenden Bereichs gebildet. Mit anderen Worten ist dann die n-Anschlussfläche 211 vollständig durch die Bodenfläche 21B gebildet. Weiter verläuft die n-Anschlussfläche 211 senkrecht zu einer Wachstumsrichtung W des Halbleiterkörpers 1, wobei die n-Anschlussfläche 211 des n-Kontaktelements 2 wenigstens 1 % und höchstens 10 %, bevorzugt wenigstens 2 % und höchstens 5 %, einer Querschnittsfläche 111 der aktiven Zone 11 beträgt. Eine n-Kontaktmetallisierung 31 ist stellenweise in der Ausnehmung 21 angeordnet und ist stellenweise mit der Anschlussfläche 211 der Ausnehmung 21 in direktem Kontakt. Ferner beträgt ein Verhältnis von einer maximalen lateralen Ausdehnung $L_{max}$. der aktiven Zone 11 zu einer n-Querleitfähigkeit des n-leitenden Bereichs 12 beispielsweise **4 $\mu m$/($\Omega$/$sq$)**.

Die n-Kontaktmetallisierung 31 ist ausgehend von der Ausnehmung 21 in lateraler Richtung aus dem Halbleiterkörper 1 herausgeführt. Mit anderen Worten ist der n-leitende Bereich 12 durch die n-Kontaktmetallisierung 31 von außen "seitlich" elektrisch kontaktiert. Auf die n-Kontaktmetallisierung 31 ist stellenweise eine Isolationsschicht 7 sowie auf die Isolationsschicht 7 die Passivierungsschicht 6 direkt aufgebracht, wobei von der Passivierungsschicht 6 und der Isolationsschicht 7 freie Stellen der Kontaktmetallisierung 31 einen elektrischen Kontaktbereich 5 ausbilden. Bei dem so gebildeten Kontaktbereich 5 handelt es sich um einen n-Kontaktbereich 51.

Eine p-Kontaktmetallisierung 32 kontaktiert den p-leitenden Bereich 13 des Halbleiterkörpers 1 über eine der Strahlungsauskoppelfläche 10 gegenüberliegende p-Anschlussfläche 131 des p-leitenden Bereichs 12. Wie in der Figur 1A dargestellt, ist ebenso die p-Kontaktmetallisierung 32 ausgehend von der p-Anschlussfläche 131 in lateraler Richtung vom Halbleiterkörper 1 herausgeführt, wobei sich die n-Kontaktmetallisierung 31 und die p-Kontaktmetallisierung 32 in vertikaler Richtung nicht miteinander überlappen. Mit anderen Worten sind die beiden Kontaktmetallisierungen 31 und 32 in verschiedene Richtungen vom Halbleiterkörper 1 herausgeführt. Von der Isolationsschicht 7 als auch der Passivierungsschicht 6 freie Stellen bilden einen weiteren Kontaktbereich 5 in Form eines p-Kontaktbereichs 52 aus. Der optoelektronische Halbleiterchip 100 ist daher "seitlich" durch die beiden Kontaktbereiche 51 und 52 extern elektrisch kontaktierbar.

Ferner umfasst der optoelektronische Halbleiterchip 100 einen Hilfsträger 9, wobei es sich bei dem Hilfsträger insbesondere nicht um ein Aufwachssubstrat handelt. Bei dem Hilfsträger 9 kann es sich um einen Halbleiterwafer der nach Art einer Scheibe oder Platte ausgebildet ist oder um eine mechanisch stabile Schicht oder Platte, die beispielsweise mit einem Metall gebildet ist, handeln,. Zwischen dem Hilfsträger 9 und dem Halbleiterkörper 1 ist auf dem Hilfsträger 9 zunächst eine Verbindungsschicht 8 angeordnet. Beispielsweise handelt es sich bei der Verbindungsschicht 8 um ein elektrisch leitfähiges Material wie zum Beispiel einem Lot. Auf eine dem Hilfsträger 9 abgewandte Fläche der Verbindungsschicht 8 ist eine Trägerisolationsschicht 4 angeordnet. Die Trägerisolationsschicht 4 und die Verbindungsschicht 8 verbinden die Kontaktmetallisierungen 31, 32 und den Halbleiterkörper 1 mechanisch fest mit dem Hilfsträger 9. Ferner isoliert die Trägerisolationsschicht 4 sowohl die n-31 und die p-Kontaktmetallisierungen 32 vollständig voneinander als auch von der Verbindungsschicht 8 und/oder dem Hilfsträger 9. Weiter ist die Trägerisolationsschicht 4 stellenweise ebenso in der Ausnehmung 21 des n-Kontaktelements 2 angeordnet. Mit anderen Worten ist die Trägerisolationsschicht 4 vollständig auf der Strahlungsauskoppelfläche 10 gegenüberliegenden Flächen des Halbleiterkörpers 1 und der Kontaktmetallisierungen 31 und 32 direkt aufgebracht.

Die Figur 1B zeigt in der schematischen Draufsicht das Ausführungsbeispiel gemäß der Figur 1A. Aus der Draufsicht ist erkennbar, dass der optoelektronische Halbleiterchip 100 eine rechteckige Grundform aufweist, wobei die Ausnehmung 21 einen rechteckigen streifenförmigen Bereich bildet, der den p-leitenden Bereich entlang einer Seite in lateraler Richtung begrenzt. Ebenso ist denkbar, dass der Halbleiterchip 100 eine von der Figur 1B abweichende Grundform aufweist, beispielsweise kann der Halbleiterchip 100 in einer Draufsicht kreisförmig, oval oder ellipsoid ausgeformt sein. Ebenso ist denkbar, dass die Ausnehmung 21 eine von der in der Figur 1B abweichende Form aufweist.

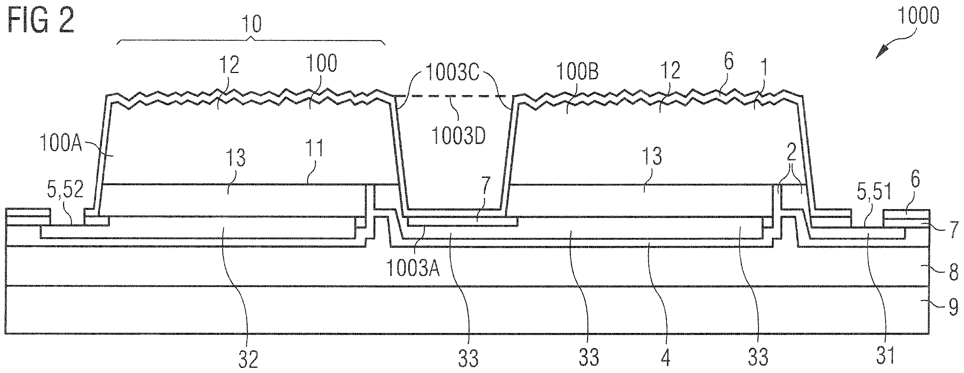

In der Figur 2 ist in einer schematischen Seitenansicht ein Ausführungsbeispiel eines hier beschriebenen optoelektronischen Halbleiterbauteils 1000 gezeigt. Das optoelektronische Halbleiterbauteil 1000 umfasst zwei optoelektronische Halbleiterchips 100 gemäß zumindest einer der hier beschriebenen Ausführungsformen. Zum besseren Verständnis sei der links dargestellte optoelektronische Halbleiterchip 100 im Folgenden als ein optoelektronischer Halbleiterchip 100A und der rechts dargestellte Halbleiterchip 100 im Folgenden als ein optoelektronischer Halbleiterchip 100B geführt. Die beiden optoelektronischen Halbleiterchips 100A und 100B sind in einer Serienschaltung miteinander elektrisch kontaktiert und sind durch einen Graben 1003 voneinander getrennt. Der n-leitende Bereich 12 des Halbleiterchips 100A ist mit dem p-leitenden Bereich 13 des Halbleiterchips 100B über eine durchgehende Zwischenmetallisierung 33 elektrisch verbunden. Vorliegend ist die Zwischenmetallisierung vollständig durch die n-Kontaktmetallisierung 31 des Halbleiterchips 100A und durch die p-Kontaktmetallisierung 32 des Halbleiterchips 100B gebildet. Mit anderen Worten sind die beiden Kontaktmetallisierungen 31 und 32 zu einer gemeinsamen Zwischenmetallisierung 33 miteinander "verbunden". Die n-Kontaktmetallisierung 31, die p-Kontaktmetallisierung 32 und die Zwischenmetallisierung 33 überlappen sich in vertikaler Richtung nicht. Der Graben 1003 ist durch zwei Seitenflächen 1003C und eine Bodenfläche 1003A gebildet. Ferner weist der Graben 1003 eine der Bodenfläche 1003A gegenüberliegende Öffnung 1003D auf. Die Bodenfläche 1003A des Grabens 1003 ist durch die Zwischenmetallisierung 33 gebildet, die zwischen den Halbleiterchips 100A und 100B verläuft. Auf die Bodenfläche 1003A des Grabens 1003 ist stellenweise eine Isolationsschicht 7 direkt aufgebracht. Ferner ist bis auf die n- und die p-Kontaktstellen 51 und 52 auf freiliegende Stellen des Halbleiterkörpers 1, des Grabens 1003 sowie der Isolationsschicht 7 die Passivierungsschicht 6 direkt aufgebracht.

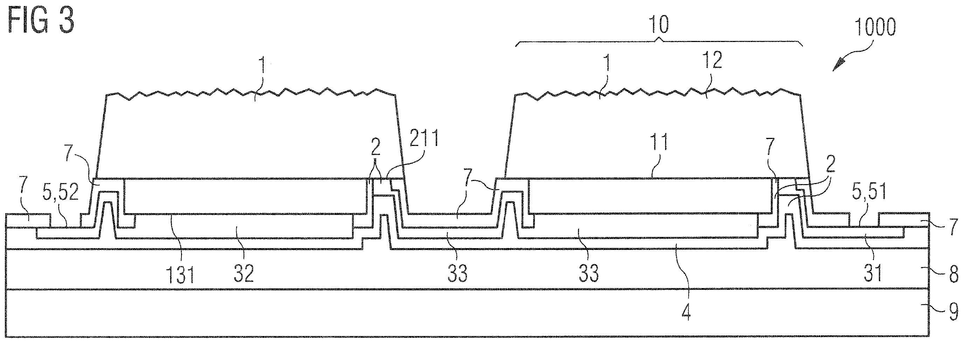

Die Figur 3 zeigt ein weiteres Ausführungsbeispiel eines hier beschriebenen optoelektronischen Halbleiterbauteils 1000. Im Unterschied zu dem in Figur 2 dargestellten Ausführungsbeispiel sind die Ausnehmungen 21 sowohl des Halbleiterchips 100A als auch des Halbleiterchips 100B in lateraler Richtung umlaufend um den p-leitenden Bereich 13 und begrenzen den p-leitenden Bereich 13 in lateraler Richtung allseitig. Durch die Ausnehmung 21 ist die aktive Zone 11 in lateraler Richtung im Vergleich zum n-leitenden Bereich 12 allseitig "zurückgezogen". Zwischen den Metallisierungen 31, 32 und 33 und dem n- 12 und p-leitenden Bereich 13 ist im Bereich der Ausnehmung 21 stellenweise die Isolationsschicht 7 zur Vermeidung eines elektrischen Kurzschlusses angeordnet. Vorteilhaft verhindert die Isolationsschicht 7 ferner eine Oxidation der aktiven Zone 11, wodurch beispielsweise auf das Aufbringen der Passivierungsschicht 6 im Bereich der aktiven Zone verzichtet werden kann. Ferner ist bei dem in der Figur 2 dargestellten Ausführungsbeispiel die Strahlungsauskoppelfläche 10 durch die Fläche 12A des n-leitenden Bereichs 12 vollständig gebildet, wobei auch in diesem Ausführungsbeispiel die Strahlungsauskoppelfläche 10 strukturiert ist.

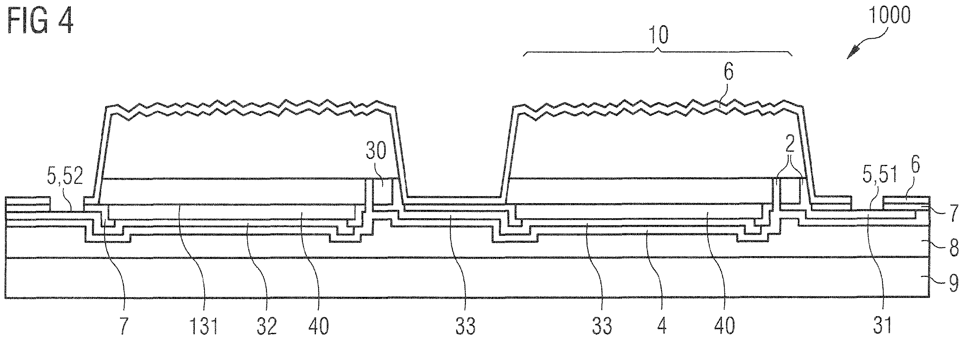

Die Figur 4 zeigt ein weiteres Ausführungsbeispiel eines hier beschriebenen optoelektronischen Halbleiterbauteils 1000. Im Unterschied zu dem in der Figur 2 dargestellten Ausführungsbeispiel weist das optoelektronische Halbleiterbauteil 1000 n-Spiegelschichten 30 und p-Spiegelschichten 40 auf. Beispielsweise sind die beiden Spiegelschichten 30 und 40 mit einem elektrisch leitfähigen Material gebildet. Die n-Spiegelschicht 30 ist stellenweise jeweils in der Ausnehmung 21 des n-Kontaktelements 2 angeordnet und steht zumindest stellenweise mit der n-Anschlussfläche 211 in direktem Kontakt. Die p-Spiegelschicht 40 ist zumindest stellenweise direkt auf die p-Anschlussfläche 131 aufgebracht. Elektromagnetische Strahlung, die von der aktiven Zone 11 in Richtung der p-Anschlussfläche 131 emittiert wird, kann vorteilhaft durch die n-Spiegelschicht 30 und die p-Spiegelschicht 40 in Richtung der Strahlungsauskoppelflächen 10 zurückreflektiert werden. Vorteilhaft erhöhen daher die Spiegelschichten 30 und 40 die Auskoppeleffizienz der einzelnen Halbleiterchips 100. "Auskoppeleffizienz" bedeutet in diesem Zusammenhang das Verhältnis zwischen primär in den Halbleiterchips 100A und 100B erzeugter Leuchtenergie zu aus den Halbleiterchips 100A und 100B ausgekoppelter Leuchtenergie.

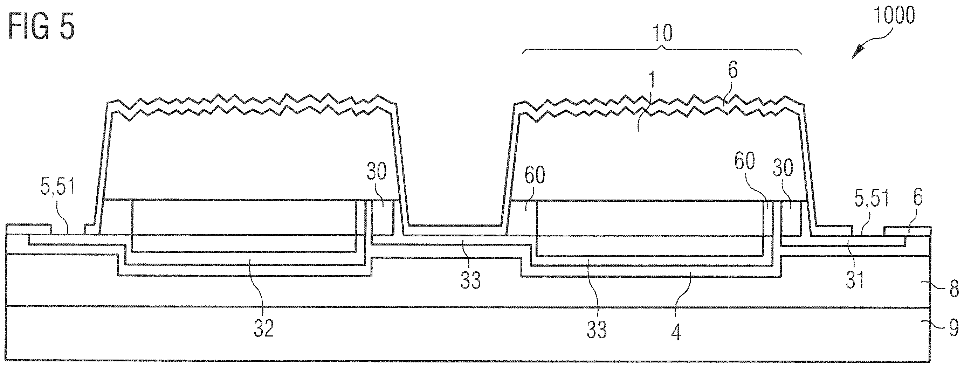

Bei dem in der Figur 5 dargestellten Ausführungsbeispiel eines hier beschriebenen optoelektronischen Halbleiterbauteils 1000 ist im Unterschied zu dem in der Figur 4 gezeigten Ausführungsbeispiel der p-leitende Bereich in lateraler Richtung allseitig von einem nominell undotierten Halbleiterbereich 60 lateral begrenzt. Der nominell undotierte Halbleiterbereich 60 und der p-leitende Bereich 13 sind durch eine durchgehende und zusammenhängende Halbleiterschicht gebildet. Vorliegend ist der nominell undotierte Halbleiterbereich 60 elektrisch isolierend. Vorteilhaft kann daher auf eine Isolationsschicht 7, insbesondere im Bereich zwischen den Metallisierungen 31, 32 und 33 und dem n-leitenden Bereich 12 und dem p-leitenden Bereich 13 verzichtet werden.

In diesem Zusammenhang ist auch denkbar, dass das n-Kontaktelement 2 zumindest stellenweise durch ein entsprechend überdotiertes Halbleitermaterial des p-leitenden Bereichs 13 gebildet ist. Mit anderen Worten kann dann das entsprechend überdotierte Halbleitermaterial den n-leitenden Bereich elektrisch kontaktieren, sodass vorteilhaft auf eine n-Kontaktmetallisierung 31 im Bereich der Ausnehmung teilweise verzichtet werden kann.

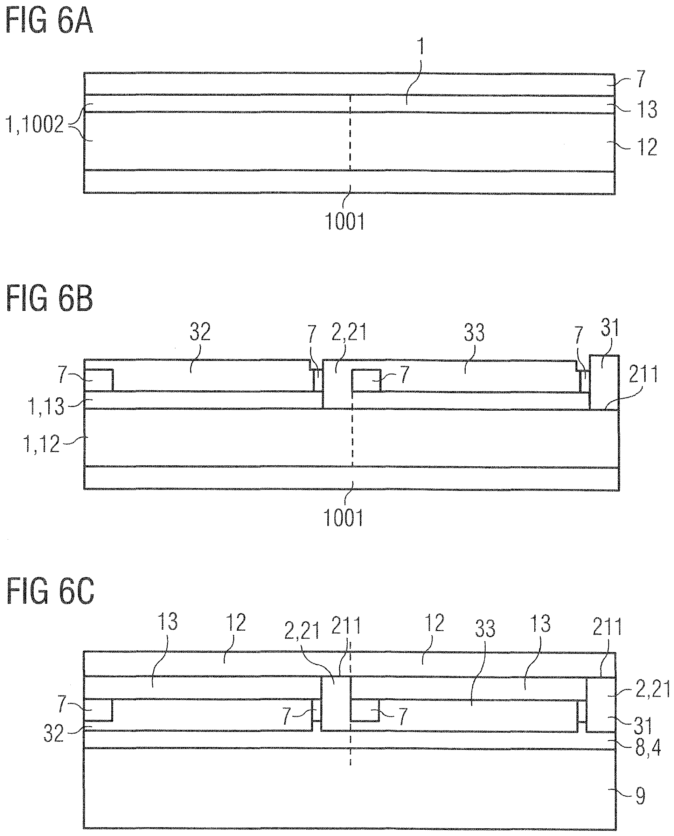

Die Figuren 6A bis 6E zeigen einzelne Fertigungsschritte zur Herstellung eines hier beschriebenen optoelektronischen Halbleiterbauteils 1000.

In der Figur 6A wird in einem ersten Schritt zunächst ein Aufwachsträger 1001 bereitgestellt. Beispielsweise handelt es sich bei dem Aufwachsträger um einen Halbleiterwafer, der nach Art einer Scheibe oder Platte ausgebildet ist. Auf den Aufwachsträger 1001 ist eine Halbleiterschichtenfolge 1002 epitaktisch abgeschieden. Die Halbleiterschichtenfolge 1002 weist einen n- 12 und einen p-leitenden Bereich 13 auf. Ferner ist auf eine dem Aufwachsträger 1 abgewandte Fläche des n-leitenden Bereichs 13 eine Isolationsschicht 7 vollständig aufgebracht.

Die Figur 6B zeigt einen nächsten Schritt, bei dem zwei n-Kontaktelemente 2 in die Halbleiterschichtenfolge 1002 erzeugt werden. Dazu wird zunächst zumindest in den Bereichen der späteren n-Kontaktelemente 2 die Isolationsschicht 7 wieder entfernt. In einem nächsten Schritt werden, beispielsweise mittels eines trocken- oder nasschemischen Ätzprozesses, die Ausnehmungen 21 in den p-leitenden Bereich 13 eingebracht, wobei sich die Ausnehmungen 21 durch den p-leitenden Bereich 13 hindurch bis in den n-leitenden Bereich 12 hinein erstrecken.

In einem nächsten Schritt wird die Isolationsschicht 7 stellenweise von dem p-leitenden Bereich 13 entfernt und an dadurch freigelegten Stellen eine n- 31 und eine die p-Kontaktmetallisierung 32 sowie eine Zwischenmetallisierung 33 aufgebracht.

In einem nächsten Schritt wird auf freiliegende Flächen der Metallisierungen 31, 32, 33, der Isolationsschicht 7 sowie dem Halbleiterkörper 1 eine Trägerisolationsschicht 4 vollständig aufgebracht.

In einem weiteren Schritt wird dann auf die der Halbleiterschichtenfolge 1002 abgewandte Fläche der Trägerisolationsschicht 4 eine Verbindungsschicht 8, beispielsweise ein metallisches Lot, aufgebracht.

In einem nächsten Schritt wird ein Hilfsträger 9 auf die dem Aufwachsträger 1001 gegenüberliegende Fläche der Verbindungsschicht 8 aufgebracht. Anschließend wird der Aufwachsträger 1001 von der Halbleiterschichtenfolge 1002 entfernt (siehe auch Figur 6C).

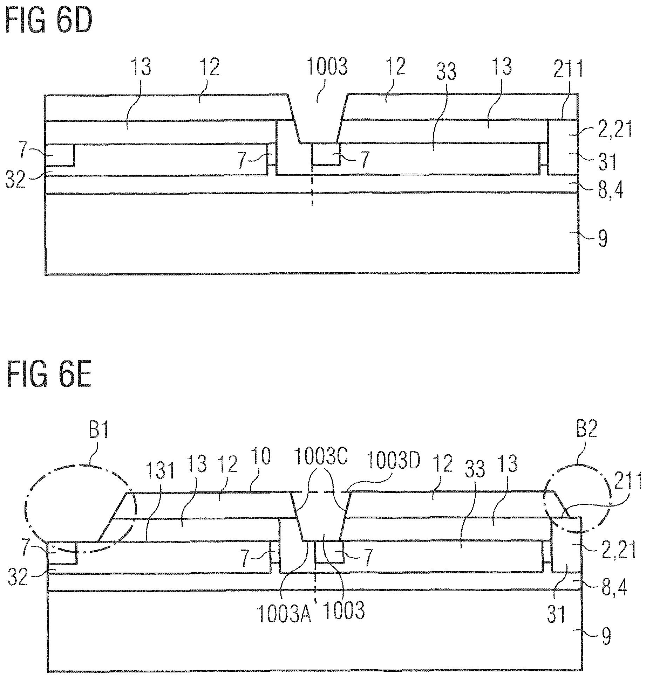

In der Figur 6D ist dargestellt, wie in einem nächsten Schritt zur Erzeugung von einzelnen Halbleiterkörpern 1 in die Halbleiterschichtenfolge 1002 ein Graben 1003 über den n-leitenden Bereich 12 zwischen in lateraler Richtung benachbarten n-Kontaktelementen 2 eingebracht wird. Der Graben 1003 ist beispielsweise mittels eines trocken- oder nasschemischen Ätzprozesses gebildet. Vorliegend ist eine Bodenfläche 1003A des Grabens 1003 stellenweise durch die Isolationsschicht 7 gebildet, wobei Seitenflächen 1003C des Grabens 1003 teilweise durch die Halbleiterschichtenfolge 1002 gebildet sind. Mit anderen Worten ist die Halbleiterschichtenfolge 1002 im Bereich des Grabens 1003 stellenweise vollständig entfernt.

In der Figur 6E ist dargestellt, wie die Halbleiterschichtenfolge 1002 in Bereichen B1 und B2 teilweise entfernt wird. Mit anderen Worten verjüngen sich die Halbleiterkörper 1 ausgehend von p-Anschlussflächen 131 in Richtung von Strahlungsauskoppelflächen 10. Beispielsweise kann auf freie Stellen der Halbleiterkörper 1, der Isolationsschicht 7 und/oder der Kontaktmetallisierungen 31, 32 und 33 eine oder mehrere Passivierungsschichten 6 aufgebracht werden, wobei die Kontaktmetallisierungen 31 und 32 zur externen elektrischen Kontaktierung stellenweise einen Bereich aufweisen, der frei von der Isolationsschicht 7 und der Passivierungsschicht 6 ist. Beispielsweise bilden diese Bereiche der Kontaktmetallisierungen 31 und 32 dann n- 51 und p-Kontaktbereiche 52 aus.

Die Erfindung ist nicht durch die Beschreibung anhand der Ausführungsbeispiele beschränkt.

**Patentansprüche**

1. Optoelektronischer Halbleiterchip (100) umfassend:

   - einen Halbleiterkörper (1), aufweisend einen n-leitenden Bereich (12) und einen p-leitenden Bereich (13), **dadurch gekennzeichnet, dass**
   - er ein einziges n-Kontaktelement (2), über das der n-leitende Bereich (12) durch den p-leitenden Bereich (13) hindurch elektrisch kontaktierbar ist, umfasst, und
   - das n-Kontaktelement (2) eine Ausnehmung (21) im p-leitenden Bereich (13) umfasst, wobei die Ausnehmung durch zumindest eine Seitenfläche (21A) und eine Bodenfläche (21B) gebildet ist, wobei die zumindest eine Seitenfläche durch Halbleitermaterial des p-leitenden Bereichs (13) gebildet ist und wobei eine vertikale Ausdehnung der Ausnehmung (21) zumindest stellenweise eine vertikale Ausdehnung des p-leitenden Bereichs (13) beträgt, und
   - das n-Kontaktelement (2) den p-leitenden Bereich (13) zumindest stellenweise lateral begrenzt,

   - das n-Kontaktelement (2) eine n-Anschlussfläche (211) aufweist, die durch ein Halbleitermaterial des n-leitenden Bereichs (13) gebildet ist, wobei die n-Anschlussfläche (211) senkrecht zu einer Wachstumsrichtung (W) des Halbleiterkörpers (1) verläuft und durch die Bodenfläche (21B) der Ausnehmung (21) gebildet ist,
   - das n-Kontaktelement (2) eine n-Kontaktmetallisierung (31) aufweist, die zumindest stellenweise direkt an die n-Anschlussfläche (211) angrenzt,
   - der Halbleiterkörper (1) eine Strahlungsauskoppelfläche (10) aufweist, die an der dem p-leitenden Bereich (13) abgewandten Seite des n-leitenden Bereichs (12) angeordnet ist,
   - bei dem der p-leitende Bereich (12) eine der Strahlungsauskoppelfläche (10) gegenüberliegende p-Anschlussfläche (131) aufweist, wobei die p-Anschlussfläche (131) mit einer p-Kontaktmetallisierung (32) elektrisch leitend verbunden ist,
   - bei dem die n- (31) und die p-Kontaktmetallisierung (32) in lateraler Richtung vom Halbleiterkörper (1) herausgeführt sind und in vertikaler Richtung nicht miteinander überlappen.

2. Optoelektronischer Halbleiterchip (100) nach dem vorhergehenden Anspruch, bei dem der Halbleiterkörper (1) eine aktive Zone (11) aufweist, wobei die n-Anschlussfläche (211) des n-Kontaktelements (2) wenigstens 1 % und höchstens 10 % einer Querschnittfläche (111) der aktiven Zone (11) beträgt.

3. Optoelektronischer Halbleiterchip (100) nach einem der vorhergehenden Ansprüche, bei dem zwischen dem p-leitenden Bereich (13) und der n-Kontaktmetallisierung (31) im Bereich der Ausnehmung (21) eine Isolationsschicht (7) angeordnet ist.

4. Optoelektronischer Halbleiterchip (100) nach einem der vorhergehenden Ansprüche, bei dem der p-leitende Bereich (13) stellenweise von einem nominell undotierten Halbleiterbereich (60) lateral begrenzt ist, wobei der nominell undotierte Halbleiterbereich (60) und der p-leitende Bereich (13) durch eine durchgehende und zusammenhängende Halbleiterschicht gebildet sind.

5. Optoelektronischer Halbleiterchip (100) nach einem der vorhergehenden Ansprüche, bei dem das n-Kontaktelement (2) zumindest stellenweise durch ein überdotiertes n-leitendes Halbleitermaterial des p-leitenden Bereichs (13) gebildet ist.

6. Optoelektronischer Halbleiterchip (100) nach einem der vorhergehenden Ansprüche, wobei die Kontaktmetallisierungen (31,32) in verschiedene Richtungen vom Halbleiterkörper 1 herausgeführt sind.

7. Optoelektronischer Halbleiterchip (100) nach einem der vorhergehenden Ansprüche, wobei der n-leitende Bereich (12) und der p-leitende Bereich (13) über die n- und p-Kontaktmetallisierung (31,32) von außen seitlich elektrisch kontaktiert sind.

8. Optoelektronisches Halbleiterbauteil (1000) umfassend:

    - zumindest zwei optoelektronische Halbleiterchips (100) gemäß einem der vorhergehenden Ansprüche, wobei
    - die optoelektronischen Halbleiterchips (100) in einer Serienschaltung miteinander elektrisch kontaktiert sind,
    - der n-leitende Bereich (12) eines Halbleiterchips (100) mit dem p-leitenden Bereich (13) eines benachbarten Halbleiterchips (100) über eine durchgehende Zwischenmetallisierung (33) elektrisch verbunden ist,
    - die Zwischenmetallisierung (33) zumindest stellenweise durch die n-Kontaktmetallisierung (31) eines Halbleiterchips (100) und durch die p-Kontaktmetallisierung (32) eines benachbarten Halbleiterchips (100) gebildet ist.

9. Verfahren zur Herstellung eines optoelektronischen Halbleiterbauteils (1000), bei dem ein optoelektronisches Halbleiterbauteil (1000) gemäß dem Anspruch 8 hergestellt wird, umfassend die folgenden Schritte:

    - Bereitstellen eines Aufwachsträgers (1001);
    - Aufbringen einer epitaktisch gewachsenen Halbleiterschichtenfolge (1002) auf den Aufwachsträger (1001), wobei die Halbleiterschichtenfolge (1002) einen n-leitenden Bereich (12) und einen p-leitenden Bereich (13) aufweist;
    - Erzeugung von zumindest zwei n-Kontaktelementen (2) in der Halbleiterschichtenfolge (1002), wobei sich die n-Kontaktelemente (2) durch den p-leitenden Bereich (13) hindurch bis in den n-leitenden Bereich (12) hinein erstrecken;
    - Aufbringen eines Hilfsträgers (9) auf die dem Aufwachsträger (1001) gegenüberliegende Fläche der Halbleiterschichtenfolge (1002) und anschließendes Entfernen des Aufwachsträgers (1001) von der Halbleiterschichtenfolge (1002);
    - Erzeugen von einzelnen Halbleiterkörpern (1) durch das Einbringen von zumindest einem Graben (1003) über den n-leitenden Bereich (12) zwischen in lateraler Richtung benachbarten n-Kontaktelementen (2), wobei im Bereich des Grabens (1003) Teile der Halbleiterschichtenfolge (1002) zumindest stellenweise vollständig entfernt werden.

## Claims

1. Optoelectronic semiconductor chip (100) comprising:

    - a semiconductor body (1) comprising an n-conducting region (12) and a p-conducting region (13), **characterized in that**
    - it comprises a single n-contact element (2) via which the n-conducting region (12) is electrically contactable through the p-conducting region (13), and
    - the n-contact element (2) comprises a recess (21) in the p-conducting region (13), the recess being formed by at least one side surface (21A) and a bottom surface (21B), the at least one side surface being formed by semiconductor material of the p-conducting region (13) and a vertical expansion of the recess (21) being at least partially a vertical expansion of the p-conducting region (13), and
    - the n-contact element (2) laterally limits the p-conducting region (13) at least in parts,
    - the n contact element (2) has an n terminal surface (211) formed by a semiconductor material of the n-conducting region (13), the n terminal surface (211) extending perpendicular to a growth direction (W) of the semiconductor body (1) and being formed by the bottom surface (21B) of the recess (21),
    - the n-contact element (2) has an n-contact metallization (31) which is directly adjacent to the n terminal surface (211) at least in places,
    - the semiconductor body (1) has a radiation decoupling surface (10) arranged on the side of the n-conducting region (12) remote from the p-conducting region (13),
    - in which the p-conducting region (12) has a p terminal surface (131) opposite the radiation decoupling surface (10), the p terminal surface (131) being electrically conductively connected to a p-contact metallization (32),
    - in which the n- (31) and the p-contact metallization (32) are led out of the semiconductor body (1) in the lateral direction and do not overlap each other in the vertical direction.

2. Optoelectronic semiconductor chip (100) according to the preceding claim, in which the semiconductor body (1) has an active zone (11), the n terminal surface (211) of the n-contact element (2) being at least 1% and at most 10% of a cross-sectional surface (111) of the active zone (11).

3. Optoelectronic semiconductor chip (100) according to one of the preceding claims, in which an insulating layer (7) is arranged between the p-conducting region (13) and the n-contact metallization (31) in the region of the recess (21).

4. Optoelectronic semiconductor chip (100) according to one of the preceding claims, wherein the p-conducting region (13) is laterally bounded in places by a nominally undoped semiconductor region (60), wherein the nominally undoped semiconductor region (60) and the p-conducting region (13) are formed by a continuous and coherent semiconductor layer.

5. Optoelectronic semiconductor chip (100) according to one of the preceding claims, in which the n-contact element (2) is at least partially formed by an overdoped n-conducting semiconductor material of the p-conducting region (13).

6. Optoelectronic semiconductor chip (100) according to one of the preceding claims, the contact metallizations (31, 32) being led out in different directions from semiconductor body 1.

7. Optoelectronic semiconductor chip (100) according to one of the preceding claims, wherein the n-conducting region (12) and the p-conducting region (13) are electrically contacted laterally from the outside via the n- and p-contact metallization (31, 32).

8. Optoelectronic semiconductor device (1000):

- at least two optoelectronic semiconductor chips (100) according to one of the preceding claims, wherein
- the optoelectronic semiconductor chips (100) are electrically contacted to each other in series,
- the n-conducting region (12) of a semiconductor chip (100) is electrically connected to the p-conducting region (13) of an adjacent semiconductor chip (100) via a continuous intermediate metallization (33),
- the intermediate metallization (33) is at least partially formed by the n-contact metallization (31) of a semiconductor chip (100) and by the p-contact metallization (32) of an adjacent semiconductor chip (100) .

9. A method of manufacturing an optoelectronic semiconductor device (1000) in which an optoelectronic semiconductor device (1000) is manufactured according to claim 8, comprising the following steps:

- providing a growth substrate (1001);

- applying an epitaxially grown semiconductor layer sequence (1002) to the growth substrate (1001), wherein the semiconductor layer sequence (1002) comprises an n-conducting region (12) and a p-conducting region (13);
- generating at least two n-contact elements (2) in the semiconductor layer sequence (1002), wherein the n-contact elements (2) extend through the p-conducting region (13) into the n-conducting region (12);
- applying an auxiliary carrier (9) to the surface of the semiconductor layer sequence (1002) opposite the growth substrate (1001) and subsequently removing the growth substrate (1001) from the semiconductor layer sequence (1002) ;
- generating individual semiconductor bodies (1) by inserting at least one trench (1003) over the n-conducting region (12) between n-contact elements (2) adjacent in the lateral direction, parts of the semiconductor layer sequence (1002) being completely removed at least in places in the region of the trench (1003) .

**Revendications**

1. Puce semi-conductrice optoélectronique (100) comprenant :

- un corps semi-conducteur (1), comportant une zone conductrice n (12) et une zone conductrice p (13), **caractérisé en ce que**
- il comprend une seule pièce de contact n (2) par l'intermédiaire de laquelle l'établissement d'un contact électrique avec la zone conductrice n (12) est possible à travers la zone conductrice p (13), et
- la pièce de contact n (2) comprend un creux (21) dans la zone conductrice p (13), le creux étant formé par au moins une face latérale (21A) et une face de fond (21B), au moins l'une des faces latérales étant formée par du matériau semi-conducteur de la zone conductrice p (13) et une étendue verticale du creux (21) correspondant, au moins par endroits, à une étendue de la zone conductrice p (13), et
- la pièce de contact n (2) limite la zone conductrice p (13) latéralement, au moins par endroits,
- la pièce de contact n (2) comprend une face de liaison n (211) qui est formée par un matériau semi-conducteur de la zone conductrice n (13), la face de liaison n (211) s'étendant verticalement à une direction de croissance (W) du corps semi-conducteur (1) et étant formée par la face de fond (21B) du creux (21),
- la pièce de contact n (2) comprend une métallisation de contact n (31) qui est, au moins par endroits, directement adjacente à la face de liaison n (211),

- le corps semi-conducteur (1) comprend une face de découplage de rayonnement (10) disposée au côté de la zone conductrice n (12) qui est détourné de la zone conductrice p (13),

- dont la zone conductrice p (12) présente une face de liaison p (131) opposée à la face de découplage de rayonnement (10), la face de liaison p (131) étant reliée de manière électro-conductrice à une métallisation de contact p (32),

- dont la métallisation de contact n (31) et la métallisation de contact p (32) sortent du corps semi-conducteur (1) dans la direction latérale et ne chevauchent pas dans la direction verticale.

2. Puce semi-conductrice optoélectronique (100) selon la revendication précédente, dont le corps semi-conducteur (1) comprend une zone active (11), la face de liaison n (211) de la pièce de contact n (2) s'élève au moins à 1 % et au plus à 10 % d'une face de section transversale (111) de la zone active (11).

3. Puce semi-conductrice optoélectronique (100) selon l'une quelconque des revendications précédentes, où une couche isolante (7) est disposée entre la zone conductrice p (13) et la métallisation de contact n (31) dans la zone du creux (21).

4. Puce semi-conductrice optoélectronique (100) selon l'une quelconque des revendications précédentes, où la zone conductrice p (13) est, par endroits, limitée latéralement par une zone semi-conductrice nominalement non dopée (60), la zone semi-conductrice nominalement non dopée (60) et la zone conductrice p (13) étant formées par une couche semi-conductrice continue et cohérente.

5. Puce semi-conductrice optoélectronique (100) selon l'une quelconque des revendications précédentes, dont la pièce de contact n (2) est, au moins par endroits, formée par un matériau semi-conducteur n surdopé de la zone conductrice p (13).

6. Puce semi-conductrice optoélectronique (100) selon l'une quelconque des revendications précédentes, les métallisations de contact (31,32) étant disposées de manière à sortir du corps semi-conducteur (1) dans des directions différentes.

7. Puce semi-conductrice optoélectronique (100) selon l'une quelconque des revendications précédentes, la zone conductrice n (12) et la zone conductrice p (13) étant mises en contact électriquement latéralement à partir de l'extérieur par l'intermédiaire des métallisations de contact n et p (31,32).

8. Composant semi-conducteur optoélectronique (1000) comprenant :

- au moins deux puces semi-conductrices optoélectroniques (100) selon l'une quelconque des revendications précédentes,

- les puces semi-conductrices optoélectroniques (100) étant mises en contact électriquement entre elles dans un montage en série,

- la zone conductrice n (12) d'une puce semi-conductrice (100) étant reliée électriquement à la zone conductrice p (13) d'une puce semi-conductrice adjacente (100) par l'intermédiaire d'une métallisation intermédiaire (33) continue,

- la métallisation intermédiaire (33) étant formée, au moins par endroits, par la métallisation de contact n (31) d'une puce semi-conductrice (100) et par la métallisation de contact p (32) d'une puce semi-conductrice adjacente (100).

9. Procédé pour l'obtention d'un composant semi-conducteur optoélectronique (1000), dans lequel un composant semi-conducteur optoélectronique (1000) selon la revendication 8 est obtenu, le procédé comportant les étapes suivantes :

- prévoir un substrat de croissance (1001);

- déposer une succession de couches semi-conductrices formées par croissance épitaxiale (1002) sur le substrat de croissance (1001), la succession de couches semi-conductrices (1002) présentant une zone conductrice n (12) et une zone conductrice p (13);

- fabriquer au moins deux pièces de contact n (2) dans la succession de couches semi-conductrices (1002), les pièces de contact n (2) s'étendant à travers la zone conductrice p (13) dans la zone conductrice n (12);

- déposer un substrat auxiliaire (9) sur la face de la succession de couches semi-conductrices (1002) opposée au substrat de croissance (1001) et ensuite enlever le substrat de croissance (1001) de la succession de couches semi-conductrices (1002);

- fabriquer des corps semi-conducteurs individuels (1) par l'insertion d'au moins un évidement (1003) au-dessus de la zone conductrice n (12) entre des pièces de contact n avoisinantes dans la direction latérale (2), des parties de la succession de couches semi-conductrices (1002) dans la zone de l'évidement (1003) étant enlevées complètement, au moins par endroits.

FIG 1A

FIG 1B

FIG 2

FIG 3

EP 2 553 726 B1

FIG 4

1000

10

6

5,52

30

2

5,51

6

7

8

9

7   131   32   40          33          33   4   40          31

FIG 5

FIG 6A

FIG 6B

FIG 6C

## FIG 6D

## FIG 6E